(19) Europäisches Patentamt
European Patent Office
Office européen des brevets

(11) EP 0 879 413 B1

(12) **EUROPÄISCHE PATENTSCHRIFT**

(45) Veröffentlichungstag und Bekanntmachung des Hinweises auf die Patenterteilung:
**26.05.1999 Patentblatt 1999/21**

(21) Anmeldenummer: **97932802.8**

(22) Anmeldetag: **10.07.1997**

(51) Int Cl.6: **G01N 29/02**, H03H 9/02, H03H 9/145

(86) Internationale Anmeldenummer:
**PCT/EP97/03667**

(87) Internationale Veröffentlichungsnummer:
**WO 98/05953 (12.02.1998 Gazette 1998/06)**

(54) **OBERFLÄCHENWELLEN-FLÜSSIGKEITSSENSOR**

SURFACE WAVE LIQUID SENSOR

DETECTEUR DE LIQUIDE A ONDES DE SURFACE

(84) Benannte Vertragsstaaten:
**DE FR GB IT**

(30) Priorität: **31.07.1996 DE 19630890**

(43) Veröffentlichungstag der Anmeldung:
**25.11.1998 Patentblatt 1998/48**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder: **LEIDL, Anton**
**D-81739 München (DE)**

(74) Vertreter: **Schoppe, Fritz, Dipl.-Ing.**
**Schoppe & Zimmermann**
**Patentanwälte**
**Postfach 71 08 67**
**81458 München (DE)**

(56) Entgegenhaltungen:
**DE-A- 2 802 946** **DE-A- 4 126 335**
**GB-A- 2 070 772** **US-A- 3 803 520**

- **ENGAN: "High-Frequency Operation of Surface-Acoustic-Wave Multielectrode Transducers" ELECTRONICS LETTERS, Bd. 10, Nr. 9, 19.September 1974, Seiten 395-396, XP002042622**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 879 413 B1

Printed by Jouve, 75001 PARIS (FR)

## Beschreibung

Die vorliegende Erfindung bezieht sich auf einen Flüssigkeitssensor und insbesondere auf einen Flüssigkeitssensor, der aus einem Oberflächenwellenbauelement aufgebaut ist.

Oberflächenwellenbauelemente werden seit Jahrzehnten in der Elektronik beispielsweise als Bandpaßfilter für den Hochfrequenzbereich eingesetzt und in hohen Stückzahlen gefertigt. Abhängig von der Wahl des als Substrat verwendeten Materials werden unterschiedliche Wellenformen angeregt. Beispielsweise werden für die Gassensorik in der Regel Rayleighwellen-Bauelemente mit einer Auslenkung senkrecht zur Oberfläche verwendet. Solche Bauelemente werden, versehen mit einer selektiven Schicht, als Bio/Chemosensoren eingesetzt.

Sollen Oberflächenwellenbauelemente als Sensoren für die Messung physikalischer Flüssigkeitseigenschaften, beispielsweise der Dichte, der Viskosität, der Schersteifigkeit, der Leitfähigkeit, der Dielektrizität usw., verwendet werden, führen Rayleighwellen-Moden zur Erzeugung von Kompressionswellen und somit zu einem hohen Energieverlust. Für Flüssigkeitssensoren werden Bauelemente, die reine Scherwellen erzeugen, eingesetzt. Dieser Wellentyp ist in verschiedenen Piezoelektrika, u.a. in allen y-rotierten Quarzschnitten, anregbar.

In den y-rotierten Quarzschnitten können jedoch auch Oberflächenscherwellen (OFSW) und Volumenscherwellen, insbesondere die sogenannten 'surface skimming bulk waves' (SSBW) angeregt werden. Oberflächenwellenbauelemente, bei denen diese Wellentypen angeregt werden, sind kommerziell beispielsweise als Bandpaßfilter im Hochfrequenzbereich, teilweise über 1 GHz, erhältlich.

Beim Einsatz derartiger Oberflächenscherwellenbauelemente als Sensoren zur Messung von Flüssigkeitseigenschaften treten Probleme auf, die bei der Anwendung derselben als Filter keine oder nur eine untergeordnete Rolle spielen. Das schwerwiegendste dieser Probleme stellt die gleichzeitige Anregung von Oberflächenscherwellen (OFSW) und Volumenscherwellen (SSBW) und die Interferenz derselben dar. Ein weiteres Problem, das zu erheblichen Störungen im Meßeffekt führen kann, ist das sogenannte 'Triple Transit Echo'. Aufgrund der durch diese Effekte, die im nachfolgenden Verlauf der vorliegenden Anmeldung noch näher erläutert werden sollen, bewirkten Probleme sind diese bekannten Bauelemente für die Flüssigkeitssensorik nicht geeignet.

Oberflächenwellensensoren der oben genannten Art sind in H. Drobe, A. Leidl, M. Rost, I.Ruge, "Acoustic sensors based on surface-localized HPSWs for measurements in liquids", in: Sensors and Actuators A, 37-38 (1993), S. 141 bis 148, beschrieben. Piezoelektrische Resonatoren auf Oberflächenwellenbasis sind ferner aus E. Benes, M. Gröschl, "Piezoelektrische Resonatoren als Sensorelemente", in : e & i, 112. Jahrgang 1995), Heft 9, S.471 bis 483, bekannt.

Der vorliegenden Erfindung liegt die Aufgabe zugrunde, Oberflächenwellensensoren für Messungen in Flüssigkeiten zu schaffen, die eine hohe Empfindlichkeit gegenüber Flüssigkeitseigenschaften und geringe entwurfsbedingte Störeinflüsse aufweisen.

Diese Aufgabe wird durch einen Flüssigkeitssensor gemäß Anspruch 1 gelöst.

Die vorliegende Erfindung schafft einen Flüssigkeitssensor bestehend aus auf einem piezoelektrischen Substrat aufgebrachten kammförmigen Elektroden als Interdigitalwandler zur Erzeugung einer elektroakustischen Welle von einem Senderwandler zu einem Empfangswandler, wobei die Anzahl von Fingerpaaren der Interdigitalwandler und das Material, aus dem die Elektroden bestehen, derart gewählt sind, daß eine durch den Senderwandler erzeugte Oberflächenscherwelle und eine durch den Senderwandler erzeugte Volumenscherwelle unterschiedliche Frequenzen aufweisen.

Das für die Elektroden gewählte Material weist vorzugsweise eine geringe Schallausbreitungsgeschwindigkeit auf. Ferner wird für die Elektroden vorzugsweise ein Material mit einer hohen Masse pro Flächeneinheit verwendet. Der Oberflächenwellen-Flüssigkeitssensor ist vorzugsweise derart aufgebaut, daß jeweils zwei Finger einer Elektrode nebeneinander angeordnet sind und ein Paar bilden, wobei ein Paar einer Elektrode mit einem benachbart angeordneten Paar der zweiten Elektrode ein Fingerquartett bildet. Die Anzahl der Finger.' quartette ist vorzugsweise größer als zweimal das Verhältnis von Anregungsfrequenz zu Frequenzabstand der Oberflächenscherwelle zu der Volumenscherwelle gewählt.

Zur Minderung der durch das sogenannte 'Triple Transit Echo' (Dreifachdurchlaufecho) erzeugten Störungen wird die Übertragungsdämpfung einer elektroakustischen Welle zwischen dem Senderwandler und dem Empfängerwandler auf eine Dämpfung zwischen 10 und 30 dB, vorzugsweise zwischen 15 und 25 dB eingestellt.

Bei dem erfindungsgemäßen Oberflächenwellensensor wird die Interferenz der Oberflächenscherwelle, die das eigentliche Nutzsignal darstellt, mit Volumenscherwellen, beispielsweise den 'surface skimming bulk waves', verhindert. Durch eine geeignete Wahl der Übertragungsdämpfung kann ferner der Einfluß durch das sogenannte 'Triple Transit Echo' und ein elektromagnetisches Übersprechen zwischen Senderwandler und Empfängerwandler deutlich verringert werden. Der erfindungsgemäße Sensor liefert gleichzeitig eine Erhöhung der Meßempfindlichkeit gegenüber der Viskosität von Flüssigkeiten. Störungen im Meßeffekt sind dadurch stark verringert.

Weiterbildungen der vorliegenden Erfindung sind den abhängigen Ansprüchen dargelegt.

Bevorzugte Ausführungsbeispiele der vorliegenden Erfindung werden nachfolgend bezugnehmend auf die

beiliegende Zeichnung näher erläutert.

Die einzige Figur zeigt das Prinzipbild eines Oberflächenwellenbauelements gemäß der vorliegenden Erfindung.

Im folgenden wird kurz eine allgemeine Beschreibung des in Fig. 1 dargestellten Oberflächenwellenbauelements gegeben. Auf einem piezoelektrischen Substrat 10, beispielsweise einem y-rotierten Quarz, sind kammförmige Elektroden 12, 14, 16 und 18 beispielsweise in Dünnfilmtechnologie aufgebracht. Die Elektroden 12 und 14 bilden einen ersten Interdigitalwandler (IDT; IDT = interdigital transducer) 20, den sogenannten Sender-Interdigitalwandler (Sender-IDT), während die Elektroden 16 und 18 einen zweiten Interdigitalwandler 22, den sogenannten Empfänger-Interdigitalwandler (Empfänger-IDT), bilden. Das Substrat kann aus einem beliebigen Piezoelektrikum bestehen, das zur Anregung von Scherwellen geeignet ist. Vorzugsweise wird ein y-rotierter Quarz mit einem Quarzschnitt zwischen 35° und 40° verwendet.

Durch das Anlegen einer hochfrequenten Wechselspannung an den Sender-IDT 20 werden aufgrund der Piezoelektrizität des Materials des Substrats 10 elektroakustische Wellen, die in Fig. 1 schematisch durch die mit dem Bezugszeichen 24 bezeichneten Pfeile dargestellt sind, angeregt. Der Abstand zwischen den Fingern der Interdigitalwandler prägt eine Wellenlänge $\lambda$ ein, wobei über die materialabhängige Ausbreitungsgeschwindigkeit $\nu$ der Welle die Anregungsfrequenz $f = \nu/\lambda$ festgelegt wird.

Wie in Fig. 1 dargestellt ist, werden zur Unterdrückung der Reflexion an den Fingern vorzugsweise sogenannte Doppelfingerwandler (double-split transducer) verwendet. Bei diesen Wandlern sind jeweils zwei Finger einer Elektrode nebeneinander angeordnet und bilden mit zwei Fingern der anderen Elektrode des Interdigitalwandlers, die neben dem Fingerpaar der ersten Elektrode angeordnet sind, ein Fingerquartett. Mit dem Bezugszeichen 26 ist ein Fingerpaar der Elektrode 16 bezeichnet. Wie in Fig. 1 ferner gezeigt ist, ist die Breite eines Fingers mit b bezeichnet, während der Abstand zwischen zwei benachbarten Fingern mit a bezeichnet ist. Die Länge des Überlappungsbereichs der Finger zweier gegenüberliegender Elektroden ist mit c bezeichnet. Die Wellenlänge $\lambda$ entspricht, wie in Fig. 1 dargestellt ist, der Länge eines Fingerquartetts, d.h. viermal der Breite eines Fingers plus viermal dem Abstand zwischen benachbarten Fingern.

Bei einer geeigneten Wahl des Substratmaterials und der Oberflächenorientierung läuft eine von dem Sender-IDT angeregte Welle entlang dieser Oberfläche und generiert im Empfänger-IDT eine hochfrequente Wechselspannung, die elektronisch ausgewertet werden kann. Änderungen der physikalischen Randbedingungen entlang der Bauelementoberfläche durch Flüssigkeiten oder Beschichtungen beeinflussen die Ausbreitungsgeschwindigkeit, d.h. die Frequenz, und die Amplitude der Wellen und können als Sensoreffekt genutzt werden.

Im folgenden wird erläutert, wie das oben beschriebene Oberflächenwellenbauelement mit einer hohen Empfindlichkeit gegenüber Flüssigkeitseigenschaften und geringen entwurfsbedingten Störeinflüssen als Flüssigkeitssensor verwendet werden kann.

Die relative Frequenzänderung einer Oberflächenwelle als Meßeffekt bei Oberflächenscherwellensensoren berechnet sich bei einer Belastung der Sensoroberfläche mit einer Newtonschen Flüssigkeit wie folgt:

$$\frac{\Delta f}{f} = c \cdot \sqrt{\frac{\eta \cdot \rho}{f}}$$

wobei c eine Proportionalitätskonstante ist, $\eta$ die Viskosität der Newtonschen Flüssigkeit ist, $\rho$ die Dichte der Newtonschen Flüssigkeit ist, und f die Frequenz ist. Die relative Frequenzänderung als Meßeffekt sinkt somit mit zunehmender Frequenz, so daß Bauelemente mit einer niedrigen Frequenz eine höhere Empfindlichkeit gegenüber Viskositätsänderungen haben. Die Eindringtiefe der Welle in die Flüssigkeit ist proportional zu $\sqrt{(2 \cdot \eta / \rho \cdot f)}$ und steigt mit sinkender Frequenz, so daß Grenzflächeneffekte bei niedrigen Frequenzen eine geringere Rolle spielen. Neben einer Vergrößerung des effektiven Meßvolumens führt daher eine niedrige Frequenz zu verbesserten Sensoreigenschaften. Bevorzugterweise werden daher Frequenzen unter 100 MHz für Oberflächenwellen-Flüssigkeitssensoren verwendet.

Neben den Oberflächenscherwellen (OFSWs) können jedoch in y-rotierten Quarzen Volumenscherwellen, beispielsweise die sogenannten 'surface skimming bulk waves' (SSBWs), angeregt werden, wie oben erwähnt wurde. Die Frequenzen der OFSWs und der SSBWs liegen sehr dicht beieinander.

In Analogie zu einem optischen Gitter, wird durch die Anzahl der Fingerquartetts der Interdigitalwandler eine Frequenzbandbreite festgelegt. Bei der üblichen Herstellung dieser Sensoren mit Aluminium als Elektrodenmaterial und der Verwendung von niedrigen Frequenzen, wie sie für die Messung der Viskosität nötig sind, überschneiden sich diese Frequenzbänder der OFSW und der SSBW, wobei beide Moden gleichzeitig angeregt werden. Aufgrund des Sensoreffekts ändert sich die Geschwindigkeit und die Dämpfung der OFSW (Oberflächenscherwelle). Die Geschwindigkeit und die Dämpfung der SSBWs ändert sich jedoch nicht, bzw. nur sehr gering. Die Interferenz der unterschiedlichen Scherwellen wird daher abhängig vom Sensoreffekt und stört empfindlich die Auswertung. Soll ein Oberflächenbauelement der oben beschriebenen Art als Flüssigkeitssensor verwendet werden, muß daher die gleichzeitige Anregung der Oberflächenscherwelle und der Volumenscherwellen verhindert werden.

Um eine Interferenz der oben genannten Art zu verhindern, muß bewirkt werden, daß die OFSW und die SSBWs unterschiedliche Frequenzen aufweisen. Durch die physikalischen Eigenschaften der Metallisierung der IDTs werden die Randbedingungen an der Grenzfläche des Quarzsubstrats zu der Metallisierung der Elektroden festgelegt. Durch eine Änderung der physikalischen Eigenschaften der Metallisierung der IDTs kann somit beispielsweise die Geschwindigkeit ν und damit die Frequenz f der OFSW erniedrigt werden. Durch eine derartige Modifikation der physikalischen Eigenschaften der Metallisierung wird die Anregungsfrequenz der SSBWs nicht oder zumindest sehr viel schwächer als die Frequenz der OFSW beeinflußt. Durch ein gezieltes Einstellen der Bandbreite der OFSW über die Fingerzahl der Interdigitalwandler und durch eine Erhöhung des Frequenzabstandes der OFSW von den SSBWs durch eine entsprechende Metallisierung kann erreicht werden, daß das Anregungsband der SSBWs außerhalb des Frequenzbands der OFSW liegt. Somit ist eine Anregung der SSBWs verhindert und eine Interferenz zwischen der OFSW und den SSBWs tritt nicht mehr auf.

Die relative Frequenzänderung der OFSW aufgrund des Elektrodenmaterials läßt sich näherungsweise nach folgender Formel berechnen:

$$\left(\frac{\Delta f}{f}\right)_m = \frac{(2\cdot\pi)^2}{2}\cdot\left(\frac{\gamma\cdot h\cdot\rho_m}{\lambda}\right)^2\cdot\frac{1}{c_{66}^2}\cdot\left[v_c^2 - v_m^2\right]^2$$

wobei $\gamma$ die Metallisierungsrate (= b/(a+b), Breite/(Breite + Abstand), der Elektroden) ist, $\rho_m$ die Dichte der Metallisierung ist, h die Schichthöhe der Metallisierung ist, $\lambda$ die Wellenlänge ist, $c_{66}$ die Schersteifigkeit von Quarz abhängig vom Schnittwinkel des Substrats ist, $\nu_m$ die Schallgeschwindigkeit der Metallisierung ist, und $\nu_c$ die Geschwindigkeit der SSBW abhängig vom Schnittwinkel des Substrats ist.

Die relative Bandbreite $(\Delta f/f)_N$, innerhalb der die Oberflächenscherwelle angeregt werden kann, ist durch-die Anzahl der Fingerquartetts N bestimmt und läßt sich berechnen zu $(\Delta f/f)_N = 2/N$.

Damit die Interferenz zwischen der OFSW und den SSBWs verhindert werden kann, muß gelten:

$$\left(\frac{\Delta f}{f}\right)_N < \left(\frac{\Delta f}{f}\right)_m$$

Somit muß $N > 2\cdot(f/\Delta f)_m$ sein.

Bei dem für die Filtertechnik üblicherweise verwendeten Aluminium als Elektrodenmaterial ergibt sich wegen der geringen Masse pro Flächeneinheit $\rho_m\cdot h\cdot\gamma$ und des geringen Unterschiedes der Schallgeschwindigkeiten zwischen Aluminium ($\nu_m$) und der SSBWs ($\nu_c$) bei einer Frequenz von ca. 50 MHz und einem y-rotierten Quarzschnitt von 36° eine Anzahl der Fingerquartetts in der Größenordnung von $10^4$. Ein Filter mit einer derartigen Fingerzahl ist zur technischen Realisierung nicht geeignet.

Für niedrige Frequenzen, beispielsweise unter 100 MHz, muß daher entsprechend obiger Gleichung eine Metallisierung mit hoher Masse pro Flächeneinheit und niedriger Schallgeschwindigkeit verwendet werden. Geeignete Materialien für die Metallisierung der Elektroden der Interdigitalwandler sind beispielsweise Gold, Platin oder Kupfer. Beispielsweise ergibt sich für Gold mit einer Schichthöhe h von 350 nm bei 65 MHz und einem y-rotierten Quarzschnitt von 36° eine Mindestanzahl von 75 Fingerquartetts.

Somit kann gemäß der vorliegenden Erfindung ein Oberflächenwellen-Flüssigkeitssensor mit einer hohen Empfindlichkeit gegenüber Flüssigkeitseigenschaften und geringen Störungen durch eine Interferenz der Oberflächenscherwelle mit Volumenscherwellen realisiert werden.

Ein weiteres Problem bei der Verwendung von Oberflächenwellenbauelementen als Flüssigkeitssensoren, das mittels eines vorteilhaften Ausführungsbeispiels der vorliegenden Erfindung gelöst werden kann, ist das Dreifachdurchlaufecho (TTE; TTE = Triple Transit Echo) und das elektromagnetische Übersprechen (EM).

Eine elektroakustische Welle, die in den Bereich des Empfänger-Interdigitalwandlers läuft, erzeugt an den Fingern, bzw. den Sammelschienen der Finger, über die angeschlossene elektrische Lastimpedanz eine Potentialdifferenz, die ihrerseits eine Oberflächenwelle generiert, die in die Richtung des Sender-Interdigitalwandlers zurückläuft und dort ebenfalls über die Generatorimpedanz eine Welle generiert, die in Richtung des Empfängers zurückläuft. Die durch diese Effekte an dem Empfänger-Interdigitalwandler ankommende, zweimal reflektierte Welle hat die Meßstrekke dreimal durchlaufen und somit die dreifache Phasenverschiebung wie die nichtreflektierte Welle erfahren. Dieser Effekt wird als Triple Transit Echo (TTE) bezeichnet. Dasselbe führt zu einer frequenzabhängigen, konstruktiven bzw.

destruktiven Interferenz zwischen direktem Meßsignal und dem zweimal reflektierten Signal. Dadurch entsteht eine frequenzabhängige Welligkeit im Übertragungsverhalten des Oberflächenwellenbauelements, wobei die Amplitude der Welligkeit von der Übertragungsdämpfung (IL; IL = insertion loss) des Bauelements und der TTE-Unterdrückung abhängt. Bei der Auswertung des durch eine Flüssigkeit auf der Oberflächenscherwelle erzeugten Sensoreffekts tritt das TTE als Störgröße auf. Der erzeugte Meßfehler hängt von der TTE-Unterdrückung, der Übertragungsdämpfung und der Größe des Meßeffektes ab.

Es ist offensichtlich, daß mit zunehmender Übertragungsdämpfung IL die TTE-Unterdrückung zunimmt. Näherungsweise gilt die Beziehung: TTE[dB] = 2·IL[dB]+12dB. Es ist somit für die Sensorik vorteilhaft, Oberflächenwellenbauelemente mit hohen Übertragungsdämpfungen von dem Sender-IDT zu dem Empfänger-IDT zu verwenden, um den Einfluß des TTE so gering wie möglich zu halten. Vorzugsweise sind Dämpfungen > 10 dB, noch vorteilhafter > 15 dB, geeignet.

Neben der TTE interferiert am Empfänger-Interdigitalwandler auch das direkte elektromagnetische Übersprechen zwischen dem Sender-IDT und dem Empfänger-IDT mit dem Signal der Oberflächenwelle und tritt in der Form einer frequenzabhängigen Welligkeit als Störgröße im Meßeffekt auf. Die Amplitude dieser Welligkeit hängt vom Amplitudenverhältnis zwischen dem elektromagnetischen Übersprechen EM und der Übertragungsdämpfung IL ab. Je kleiner dieses Verhältnis ist, desto geringer ist der Einfluß des Übersprechens auf das Meßergebnis. Das elektromagnetische Übersprechen hängt vom Aufbau des Oberflächenwellenbauelements ab. In der Praxis kann eine Dämpfung des elektromagnetischen Übersprechens EM im Bereich von 50 bis 80 dB erreicht werden. Um den Einfluß des EM klein zu halten, muß also die Übertragungsdämpfung IL klein gehalten werden, d.h. es muß eine große Amplitude der Oberflächenwelle gewährleistet sein.

Wie aus dem vorhergehenden offensichtlich ist, existiert somit ein Konflikt zwischen der zur Unterdrückung des TTE erforderlichen hohen Übertragungsdämpfung und der zum Minimieren des Effekts des elektromagnetischen Übersprechens erforderlichen geringen Übertragungsdämpfung. Damit sich beide Effekte die Waage halten, muß folgende Gleichung gelten:

$$EM[dB] = IL[dB]+TTE[dB] = 3 \cdot IL[dB]+12dB$$

Für die Übertragungsdämpfung ergibt sich somit:

$$IL[dB] = (EM[dB]-12dB)/3$$

Je nach für ein bestimmtes Oberflächenbauelement erreichbarer Unterdrückung des elektromagnetischen Übersprechens ergibt sich damit ein Bereich von 10 dB bis 30 dB, vorzugsweise von 15 dB bis 25 dB, als Übertragungsdämpfung für Oberflächenwellensensoren.

Die Übertragungsdämpfung von Oberflächenscherwellen-Bauelementen hängt vom Quarzschnitt des verwendeten Substrats, von $(\Delta f/f)_m$, von der Anzahl und der Überlappungslänge c der Finger der IDTs (siehe Fig. 1) und von einer elektrischen Anpassung an die Impedanz des angeschlossenen Meßgerätes ab. Diese Parameter müssen beim Entwurf des Oberflächenbauelements berücksichtigt werden, um eine entsprechende Übertragungsdämpfung, die den obigen Voraussetzungen genügt, zu erreichen.

Im folgenden werden anhand eines konkreten Ausführungsbeispiels exakte Parameter angegeben, die zur Realisierung eines erfindungsgemäßen Oberflächenwellen-Flüssigkeitssensors geeignet sind. Als Substrat ist ein y-rotierter Quarz mit einem Quarzschnitt von 36° verwendet. Als Metallisierung für die Elektroden der Interdigitalwandler ist Gold einer Schichthöhe h von 350 nm verwendet. Die Metallisierungsrate $\gamma$, d.h. das Verhältnis b/(b+a), ist 0,5, d. h. 50%. Bei einer Anregungsfrequenz f von 65,6 MHz ergibt sich eine Wellenlänge $\lambda$ von 76 $\mu$m. Die Anzahl der Fingerquartetts bei einem sogenannten 'double-split'-Wandler ist 90. Die Fingerüberlappung c beträgt 25 $\lambda$. Das derart dimensionierte Oberflächenwellenfilter weist eine Übertragungsdämpfung von 20 dB auf.

Die vorliegende Erfindung schafft somit Oberflächenwellen-Flüssigkeitssensoren, die zur Messung physikalischer Flüssigkeitseigenschaften, beispielsweise der Dichte, der Viskosität, der Schersteifigkeit, der Dielektrizität, der Leitfähigkeit, usw., verwendet werden können, wobei der Effekt von Laufzeit- und Dämpfungs-Änderungen von Oberflächenscherwellen in einem Oberflächenwellenbauelement, das gemäß der vorliegenden Erfindung dimensioniert ist, ausgewertet wird. Dabei ist der Entwurf der Sensoren derart optimiert, daß der Einfluß von Reflexionen und Interferenzen mit anderen Wellenformen auf die Meßgrößen minimiert ist.

## Patentansprüche

1. Flüssigkeitssensor mit auf einem piezoelektrischen Substrat (10) aufgebrachten kammförmigen Elektroden (12, 14, 16, 18) als Interdigitalwandler (20, 22) zur Erzeugung einer elektroakustischen Welle (24) von einem Senderwandler (20) zu einem Empfängerwandler (22), wobei der Senderwandler (20) eine Oberflächenscherwelle und eine Volumenscherwellen erzeugt, dadurch gekennzeichnet,
daß die Anzahl von Fingerpaaren (26) der Interdigitalwandler (20, 22) und das Material, aus dem die Elektroden (12, 14, 16, 18) bestehen, derart gewählt sind, daß die vom Senderwandler (20) erzeugte Oberflächenscherwelle und die vom Senderwandler (20) erzeugte Volumenscherwelle unterschiedliche Frequenzen aufweisen.

2. Flüssigkeitssensor gemäß Anspruch 1, dadurch gekennzeichnet,
daß das gewählte Elektrodenmaterial eine geringe Schallausbreitungsgeschwindigkeit aufweist.

3. Flüssigkeitssensor gemäß Anspruch 1 oder 2, dadurch gekennzeichnet,
daß das gewählte Elektrodenmaterial eine hohe Masse pro Flächeneinheit aufweist.

4. Flüssigkeitssensor gemäß einem der Ansprüche 1 bis 3, dadurch gekennzeichnet,
daß bei den Interdigitalwandlern (20, 22) jeweils zwei Finger einer Elektrode (12, 14, 16, 18) nebeneinander angeordnet sind und ein Paar (26) bilden, wobei ein Paar einer Elektrode mit einem benachbart angeordneten Paar der zweiten Elektrode ein Fingerquartett bildet.

5. Flüssigkeitssensor gemäß Anspruch 4, dadurch gekennzeichnet, daß die Anzahl N der Fingerquartetts gemäß folgenden Formeln berechnet wird:

$$\left(\frac{\Delta f}{f}\right)_m = \frac{(2\cdot\pi)^2}{2}\cdot\left(\frac{\gamma\cdot h\cdot\rho_m}{\lambda}\right)^2\cdot\frac{1}{c_{66}^2}\cdot\left[v_c^2 - v_m^2\right]^2,$$

$$\left(\frac{\Delta f}{f}\right)_N < \left(\frac{\Delta f}{f}\right)_m \quad \text{und} \quad N > 2\cdot(f/\Delta f)_m,$$

wobei $\Delta f$ der Frequenzabstand der Oberflächenscherwelle zu der Volumenscherwelle ist, f die Anregungsfrequenz des Senderwandlers ist, $\gamma$ das Verhältnis Breite/(Breite + Abstand) der Elektrodenfinger ist, h die Höhe der Elektroden ist, $\rho_m$ die Dichte des Elektrodenmaterials ist, $\lambda$ die Wellenlänge ist, $c_{66}$ der Schersteifigkeitskoeffizient des Substratmaterials abhängig vom Schnittwinkel ist, $v_c$ die Geschwindigkeit der Volumenscherwelle abhängig vom Schnittwinkel ist, und $v_m$ die Schallausbreitungsgeschwindigkeit in dem Elektrodenmaterial ist.

6. Flüssigkeitssensor gemäß einem der Ansprüche 1 bis 5, dadurch gekennzeichnet,
daß das Substrat (10) ein y-rotierender Quarz mit einem Quarzschnitt zwischen 35° und 40° ist.

7. Flüssigkeitssensor gemäß einem der Ansprüche 1 bis 6, dadurch gekennzeichnet,
daß die Elektroden (12, 14, 16, 18) aus Gold, Platin oder Kupfer bestehen.

8. Flüssigkeitssensor gemäß einem der Ansprüche 1 bis 7, dadurch gekennzeichnet,
daß der Quarzschnitt des piezoelektrischen Substrats (10), das Material der Elektroden (12, 14, 16, 18) und die Anzahl und die Überlappung der Fingerpaare der Interdigitalwandler (20,22) derart gewählt sind, daß die Übertragungsdämpfung (IL) einer elektroakustischen Welle zwischen dem Senderwandler (20) und dem Empfängerwandler (22) zwischen 10 und 30 dB, vorzugsweise zwischen 15 und 25 dB eingestellt ist.

9. Flüssigkeitssensor gemäß Anspruch 8, dadurch gekennzeichnet,
daß die einzustellende Übertragungsdämpfung (IL) abhängig von dem elektromagnetischen Übersprechen (EM) zwischen dem Senderwandler (20) und dem Empfängerwandler (22) wie folgt berechnet wird:

$$IL[dB] = (EM[dB]-12dB)/3.$$

**10.** Flüssigkeitssensor gemäß einem der Ansprüche 1 bis 9, dadurch gekennzeichnet, daß die Anregungsfrequenz (f) des Senderwandlers unter 100 MHz liegt.

## Claims

**1.** A liquid sensor comprising comb-shaped electrodes (12, 14, 16, 18), applied to a piezoelectric substrate (10), as interdigital transducers (20, 22) for generating an electroacoustic wave (24) from a transmitting transducer (20) to a receiving transducer (22), where the transmitting transducer (20) generates a surface shear wave and a bulk shear wave, wherein
the number of finger pairs (26) of the interdigital transducers (20, 22) and the material out of which the electrodes (12, 14, 16, 18) are made are so chosen that the surface shear wave generated by the transmitting transducer (20) and the bulk shear wave generated by the transmitting transducer (20) have different frequencies.

**2.** The liquid sensor according to claim 1, characterized in that
the selected electrode material has a small acoustic propagation speed.

**3.** The liquid sensor according to claims 1 or 2, characterized in that
the selected electrode material has a high mass per unit area.

**4.** The liquid sensor according to one of claims 1 to 3, characterized in that
for the interdigital transducers (20, 22), two fingers of an electrode (12, 14, 16, 18) are arranged next to one another in each case and form a pair (26), a pair of one electrode forming a finger quartet with a neighbouring pair of the second electrode.

**5.** The liquid sensor according to claim 4, characterized in that the number N of finger quartets is calculated according to the following formulae:

$$\left(\frac{\Delta f}{f}\right)_m = \frac{(2\cdot\pi)^2}{2}\cdot\left(\frac{\gamma\cdot h\cdot\rho_m}{\lambda}\right)^2\cdot\frac{1}{c_{66}^2}\cdot\left[v_c^2 - v_m^2\right]^2,$$

$$\left(\frac{\Delta f}{f}\right)_N < \left(\frac{\Delta f}{f}\right)_m \quad \text{und} \quad N > 2\cdot(f/\Delta f)_m,$$

where $\Delta f$ is the frequency difference between the surface shear wave and the bulk shear wave, f is the excitation frequency of the transmitting transducer, $\gamma$ is the ratio width/(width + distance) of the electrode fingers, h is the height of the electrodes, $\rho_m$ is the density of the electrode material, $\lambda$ is the wavelength, $c_{66}$ is the shear rigidity coefficient of the substrate material as a function of the cutting angle, $v_c$ is the speed of the bulk shear wave as a function of the cutting angle, and $v_m$ is the acoustic propagation speed in the electrode material.

**6.** The liquid sensor according to one of claims 1 to 5, characterized in that
the substrate (10) is a y-rotated quartz crystal with a quartz crystal cut between 35° and 40°.

**7.** The liquid sensor according to one of claims 1 to 6, characterized in that
the electrodes (12, 14, 16, 18) are made of gold, platinum or copper.

**8.** The liquid sensor according to one of claims 1 to 7, characterized in that
the quartz crystal cut of the piezoelectric substrate (10), the material of the electrodes (12, 14, 16, 18) and the number and the overlapping of the finger pairs of the interdigital transducers (20, 22) are so chosen that the insertion

loss (IL) of an electroacoustic wave between the transmitting transducer (20) and the receiving transducer (22) is set to between 10 and 30 dB, preferably between 15 and 25 dB.

9. The liquid sensor according to claim 8, characterized in that the insertion loss (IL) which is to be set is calculated as a function of the electromagnetic crosstalk (EM) between the transmitting transducer (20) and the receiving transducer (22) as follows:

$$IL[dB] = (EM[dB]-12dB)/3.$$

10. The liquid sensor according to one of claims 1 to 9, characterized in that the excitation frequency (f) of the transmitting transducer lies below 100 MHz.

## Revendications

1. Détecteur de fluide avec des électrodes en forme de doigts (12, 14, 16, 18) appliquées sur un substrat piézoélectrique (10) comme transducteurs interdigitaux (20, 22) destinés à générer une onde électroacoustique (24) d'un transducteur émetteur (20) vers un transducteur récepteur (22), le transducteur émetteur (20) générant une onde de cisaillement de surface et une onde de cisaillement volumétrique, caractérisé par le fait que le nombre de paires de doigts (26) des transducteurs interdigitaux (20, 22) et le matériau dans lequel sont réalisées les électrodes (12, 14, 16, 18) sont choisis de telle sorte que l'onde de cisaillement de surface générée par le transducteur émetteur (20) et l'onde de cisaillement volumétrique générée par le transducteur émetteur (20) présentent des fréquences différentes.

2. Détecteur de fluide suivant la revendication 1, caractérisé par le fait que le matériau d'électrodes choisi présente une faible vitesse de propagation acoustique.

3. Détecteur de fluide suivant la revendication 1 ou 2, caractérisé par le fait que le matériau d'électrodes choisi présente une grande masse par unité de surface.

4. Détecteur de fluide suivant la revendication 1 à 3, caractérisé par le fait que, dans les transducteurs interdigitaux (20, 22), chaque fois deux doigts d'une électrode (12, 14, 16, 18) sont disposés adjacents et forment une paire (26), une paire d'une électrode formant un quartet de doigts avec une paire, disposée adjacente, de la seconde électrode.

5. Détecteur de fluide suivant la revendication 4, caractérisé par le fait que le nombre N de quartets de doigts est calculé selon les formules suivantes:

$$\left(\frac{\Delta f}{f}\right)_m = \frac{(2\cdot\pi)^2}{2}\cdot\left(\frac{\gamma\cdot h\cdot\rho_m}{\lambda}\right)^2\cdot\frac{1}{c_{66}^2}\cdot\left[v_c^2-v_m^2\right]^2,$$

$$\left(\frac{\Delta f}{f}\right)_N < \left(\frac{\Delta f}{f}\right)_m \quad \text{et } N > 2\cdot(f/\Delta f)_m,$$

où $\Delta f$ est l'écart de fréquence entre l'onde de cisaillement de surface et l'onde de cisaillement volumétrique, $f$ est la fréquence d'activation du transducteur émetteur, $\gamma$ est le rapport largeur/(largeur + distance) des doigts d'électrode, h est la hauteur des électrodes, $\rho_m$ est la densité du matériau d'électrode, $\lambda$ est la longueur d'onde, $c_{66}$ est le coefficient de résistance au cisaillement du matériau de substrat fonction de l'angle de coupe, $v_c$ est la vitesse de l'onde de cisaillemnt volumétrique fonction de l'angle de coupe, $v_m$ est la vitesse de propagation acoustique dans le matériau d'électrode.

6. Détecteur de fluide suivant l'une des revendications 1 à 5, caractérisé par le fait que le substrat (10) est un quartz à rotation y à coupe de quartz entre 35° et 40°.

**7.** Détecteur de fluide suivant l'une des revendications 1 à 6, caractérisé par le fait que les électrodes (12, 14, 16, 18) sont réalisées en or, platine ou cuivre.

**8.** Détecteur de fluide suivant l'une des revendications 1 à 7, caractérisé par le fait que la coupe de quartz du substrat piézoélectrique (10), le matériau des électrodes (12, 14, 16, 18) et le nombre et le recouvrement des paires de doigts des transducteurs interdigitaux (20, 22) sont choisis de telle sorte que l'atténuation de transmission (IL) d'une onde électroacoustique entre le transducteur émetteur (20) et le transducteur récepteur (22) est réglée entre 10 et 30 dB, de préférence entre 15 et 25 dB.

**9.** Détecteur de fluide suivant la revendication 8, caractérisé par le fait que l'atténuation de transmission (IL) à régler est calculée, en fonction du chevauchement électromagnétique (EM) entre le transducteur émetteur (20) et le transducteur récepteur (22), comme suit:

$$IL(dB) = (EM(dB)-12dB)/3$$

**10.** Détecteur de fluide suivant l'une des revendications 1 à 9, caractérisé par le fait que la fréquence d'activation ($f$) du transducteur émetteur est inférieure à 100 MHz.

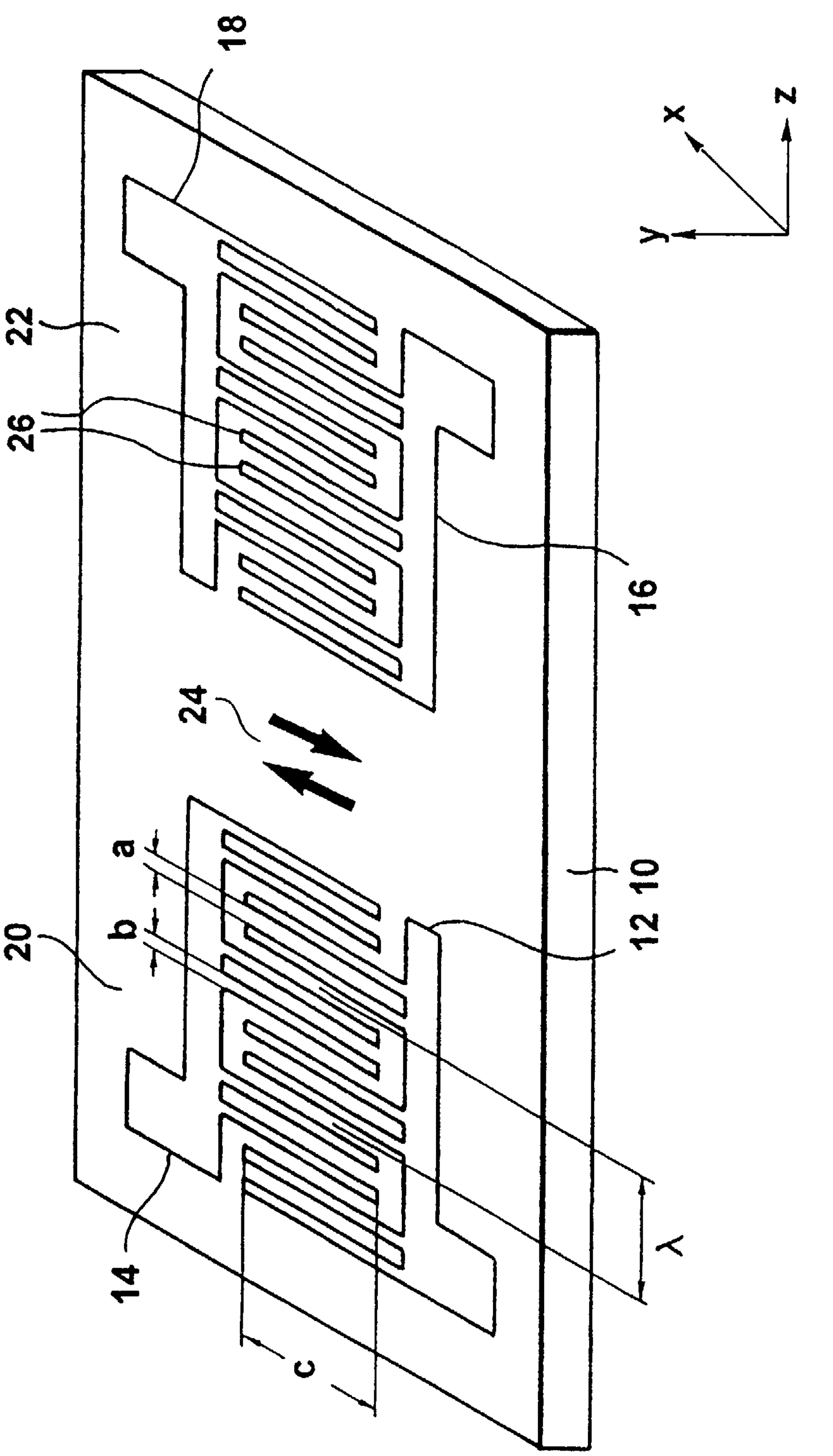


FIG.1